# EUROPÄISCHE PATENTANMELDUNG

(11) **EP 1 626 432 A1**
(43) Veröffentlichungstag der Anmeldung: **15.02.2006**
(21) Anmeldenummer: 04018925.0
(22) Anmeldetag: 10.08.2004
(51) Int. Cl.: H01J 37/34, C23C 14/35

(54) **Magnetronsputtereinrichtung, Zylinderkathode und Verfahren zur Aufbringung von dünnen Schichten aus unterschiedlichen Materialien auf einem Substrat**

(71) Anmelder: Applied Films GmbH & Co. KG, 63755 Alzenau (DE)
(72) Erfinder: Krempel-Hesse, Jörg, Dr., 63683 Eckartsborn (DE); Lopp, Andreas, Dr., 63579 Freigericht-Somborn (DE); Stolley, Tobias, 60598 Frankfurt am Main (DE); Bangert, Stefan, 36396 Steinau (DE); König, Michael, 60529 Frankfurt am Main (DE)
(74) Vertreter: GROSSE BOCKHORNI SCHUMACHER

(57) **Zusammenfassung**

Die Erfindung betrifft eine Magnetronsputtereinrichtung, welche insbesondere mindestens eine Vakuumkammer aufweist und insbesondere zur kontinuierlichen Aufbringung von mehreren Schichten unterschiedlicher Materialien auf einem Substrat vorgesehen ist und mit einer um die axiale Längsachse drehbar gelagerten Zylinderkathode (1, 1') und einem Magnetsystem versehen ist, das im Inneren der Zylinderkathode (1, 1') angeordnet ist. Die Zylinderkathode (1, 1') umfasst mindestens zwei Segmente (2, 2', 3, 3', 4, 4') mit unterschiedlichen Targetmaterialien. Die Magnetronsputtereinrichtung weist Mittel zum Drehen der Zylinderkathode (1, 1') und Mittel zum Oszillieren der Zylinderkathode (1, 1') um die Längsachse über dem innenliegenden Magnetsystem auf. Außerdem weisen die Mittel zum Oszillieren eine Begrenzungseinrichtung auf. Weiterhin betrifft die Erfindung ein Verfahren zur Aufbringung von dünnen Schichten aus unterschiedlichen Materialien auf einem Substrat durch Magnetronsputtern in einer Vakuumbeschichtungsanlage.

## Beschreibung

Die Erfindung betrifft eine Magnetronsputtereinrichtung, eine Zylinderkathode und ein Verfahren zur Aufbringung von dünnen Schichten aus unterschiedlichen Materialien auf einem Substrat gemäß den Oberbegriffen von Anspruch 1, Anspruch 4 bzw. Anspruch 10.

Magnetronsputtereinrichtungen, d.h. Targets mit Magnetaufbauten, die es ermöglichen, in Richtung eines Substrates zu sputtern, sind seit längerem in der Anwendung in Vakuumbeschichtungsanlagen zur Beschichtung von verschiedenen Substraten bekannt und für die Beschichtung mit den verschiedensten Schichtmaterialien geeignet. Solche Vakuumbeschichtungsanlagen umfassen Arbeitskammern in denen die Beschichtung erfolgt. Diese Vakuumkammern weisen einen Basisdruck in einem erforderlichen Vakuumbereich auf, der entsprechend der Prozessparameter insbesondere Kontaminationen während der Schichtabscheidung verhindert. Während der Beschichtung weisen die Vakuumkammern einen Arbeitsdruck auf, der deutlich über dem Basisdruck liegen kann und durch das Prozessgas bedingt ist.

Insbesondere Magnetronsputtereinrichtungen mit Rohrmagnetrons weisen eine vorteilhaft hohe Ausnutzungsrate des Targetmaterials und eine lange Targetstandzeit auf. Zur Anwendung kommen dabei Rohrkathoden die vollständig aus einem Targetmeterial aufgebaut sind, wie sie z.B. die DD 217 964 beschreibt. Andererseits können auch Trägerrohre verwendet werden, die mit einer umlaufend aufgetragenen Schicht aus Targetmaterial versehen sind, wie sie die US 4,356,073 beschreibt. Durch die gleichförmige Rotation der Rohrkathode wird eine gleichmäßige Erosion des Targetmaterials auf der Rohrkathodenoberfläche erzielt, da eine lokal konzentrierte Zerstäubung und somit eine Furchenbildung verhindert wird.

Zur Aufbringung von mehreren Schichten aus unterschiedlichem Material auf einem Substrat, z.B. bei Entspiegelungsschichten für die Optik oder bei Bragg-Reflektoren für die Opto-Elektronik, kommen bisher zwei verschiedene Verfahren zur Anwendung. Zum einen kann das Substrat nacheinander in verschiedene Vakuumkammern transportiert werden, in denen sich eine oder mehrere Sputterkathoden befinden. Alle Kathoden einer Kammer haben dabei das gleiche Targetmaterial. Zur Aufbringung der unterschiedlichen Schichten wird das Substrat von einer Kammer in eine andere Kammer transportiert, und jeweils mit einer Schicht eines Targetmaterials beschichtet. Nachdem die gewählte Schichtdicke erzielt ist, wird das Substrat in eine andere Kammer transportiert und mit einer weiteren Schicht versehen. Nachteilig an diesem Verfahren ist es, dass durch den Transport des Substrates durch mehrere Vakuumkammern eine sehr große Vakuumanlage notwendig ist. Dies macht die Anlage in Anschaffung und Unterhalt sehr teuer. Außerdem können durch den Transport Partikel generiert werden, die das Substrat verunreinigen können.

Andererseits können in einer einzelnen Vakuumkammer mehrere planare Targets aus unterschiedlichem Material angeordnet sein, wie z.B. in der US 2003/0085122 beschrieben. Die einzelnen Targets, die jeweils eigene Magnetsysteme besitzen, werden sukzessive vor das Substrat gedreht und ein Film gewünschter Dicke auf dem Substrat aufgebracht. In einer Vakuumkammer können sich mehrere Substrathalter befinden. Nachteilig an den Planartargets ist es, dass mit ihnen nur eine geringe Targetausnutzung möglich ist und dass sie einen großen Redepositionsbereich aufweisen. Die großen Redepositionszonen bereiten prozesstechnische Schwierigkeiten und führen zu einer schlechteren Schichtqualität auf dem Substrat.

Aufgabe der vorliegenden Erfindung ist es deshalb, eine Magnetronsputtereinrichtung, eine Zylinderkathode und ein Verfahren zur Verfügung zu stellen, mit denen es möglich ist, Schichten von unterschiedlichem Material auf einem Substrat aufzubringen, ohne dass ein Transport des Substrates zwischen der Aufbringung der unterschiedlichen Schichten erforderlich ist. Dabei soll die Targetausnutzung möglichst groß und die Redeposition auf dem Target möglichst klein sein.

Diese Aufgabe wird erfindungsgemäß gelöst durch eine Magnetronsputtereinrichtung gemäß Anspruch 1, eine Zylinderkathode gemäß Anspruch 4 und ein Verfahren gemäß Anspruch 10. Vorteilhafte Weiterbildungen der Erfindung sind durch die in den Unteransprüchen enthaltenen Merkmale gekennzeichnet.

Die erfindungsgemäße Magnetronsputtereinrichtung, welche insbesondere mindestens eine Vakuumkammer umfasst und insbesondere zur kontinuierlichen Aufbringung von mehreren Schichten unterschiedlicher Materialien auf einem Substrat vorgesehen ist, ist mit einer um die axiale Längsachse drehbar gelagerten Zylinderkathode und einem Magnetsystem versehen. Das Magnetsystem ist im Innern der Zylinderkathode angeordnet. Die Zylinderkathode umfasst mindestens zwei Segmente mit unterschiedlichen Targetmaterialien und die Magnetronsputtereinrichtung weist Mittel zum Drehen der Zylinderkathode auf, mit deren Hilfe die Zylinderkathode (1, 1') zur Aufbringung einer Schicht so weit um die Längsachse gedreht wird, bis sich das Segment (2, 2', 3, 3', 4, 4') mit dem gewünschten Material über dem Magnetsystem befindet. Weiterhin weist die Magnetronsputtereinrichtung Mittel auf zur Oszillation der Zylinderkathode um die Längsachse über dem innenliegenden Magnetsystem während der Aufbringung der Schichten auf dem Substrat, wobei die Oszillation durch Drehung abwechselnd im und gegen den Uhrzeigersinn erfolgt. Außerdem weist die Magnetronsputtereinrichtung Mittel zur Begrenzung der Oszillation auf, so dass nur Material einer Sorte gesputtert wird.

Zweckmäßig umfasst die Magnetronsputtereinrichtung mehrere Zylinderkathoden. Mit einer solchen Magnetronsputtereinrichtung lassen sich mehrere Schichten in Folge auf einem Substrat aufbringen, wobei auch sehr großflächige Substrate beschichtet werden können. Die Magnetronsputtereinrichtung kann dabei sehr kompakt gestaltet werden, da im Gegensatz zu einer Magnetronsputtereinrichtung mit Mehrfachplanartargets nur ein Magnetsystem erforderlich ist. Die Vakuumbeschichtungsanlagen können durch den Einsatz der erfindungsgemäßen Magnetronsputtereinrichtung in ihrer Größe deutlich reduziert werden. Dadurch können die Kosten der Anschaffung und des Unterhalts, der neben den reinen Betriebskosten ja auch die Kosten für die benötigte Stellfläche umfasst, verringert werden. Zur Aufbringung vieler verschiedener aufeinanderfolgender Schichten kann es vorteilhaft sein, wenn die Magnetronsputtereinrichtung mehrere verschiedene Zylinderkathoden umfasst, die unterschiedliche Kombinationen von Targetmaterialien aufweisen.

Die erfindungsgemäße Zylinderkathode, die insbesondere in der oben beschriebenen Magnetronsputtervorrichtung Verwendung finden kann, umfasst mindestens zwei Segmente mit unterschiedlichen Targetmaterialien. Vorteilhaft ist es, wenn die einzelnen Segmente als Zylindersegmente ausgebildet sind. Jedoch kann es auch notwendig sein, die Segmente an ihrer Außenseite planar auszuführen, wenn die Aufbringung der Segmente z.B. mittels Plasmaspritzen nicht möglich ist. Beispielsweise lassen sich keramische Stoffverbindungen im Plasmaspritzverfahren nicht immer mit einer erforderlichen Materialdichte und -homogenität auf einem Rohrtarget aufbringen.

Insbesondere, wenn die einzelnen Segmente direkt aneinander grenzen, steht eine große Targetfläche für die einzelnen Materialien zur Verfügung. Die Zylinderkathode kann jedoch auch einzelne Segmente umfassen, die mit Abstand zueinander angeordnet sind. Dieser Abstand ist dabei jedoch so zu bemessen, dass in dem Spalt zwischen den Segmenten gerade noch keine Entladung auftreten kann.

Zur Unterstützung, z.B. bei dünnen oder auch mechanisch ungenügend stabilen Segmenten, können die einzelnen Segmente auf einem Trägerrohr angeordnet sein.

Grundsätzlich können alle Metalle, Metalloxide und Materialien, aus denen wegen Fertigungsproblemen keine selbsttragenden Segmente hergestellt werden können (hierzu zählen insbesondere ITO, IZO, ZAO, Chrom oder Wolfram) auf Trägerrohren aufgebracht werden. Herstellungsverfahren hierfür sind zum Beispiel heiß-isostatisches Pressen, Plasmaspritzen und Bonden oder Kleben. Hingegen können alle Metalle, aus denen man selbsttragende Segmente, zum Beispiel durch Schneiden, Ziehen, Fräsen, Biegen oder Walzen herstellen kann, wobei man die Segmente beispielweise durch Löten oder Schweißen, aber auch durch mechanische Lösungen wie Schwalbenschwanzführungen miteinander zu einem Target verbinden kann, zur Herstellung von Volltargets verwendet werden. Dies gilt insbesondere für Zinn, Zink, Nickel, Kupfer, Aluminium, Silber, Gold, Platin, Molybdän, Titan und Neodym.

Typische Abmessungen für die Zylinderkathodentargets sind Längen von 500 bis 4500 mm, Durchmesser von 100 bis 300 mm und Wandstärken von 1 bis 50 mm.

Um die Zylinderkathode optimal nutzen zu können, ist es zweckmäßig, wenn die Kreisbögen der einzelnen Zylindersegmente eine solche Größe aufweisen, dass die Volumina der Segmente so den Sputterbedingungen der einzelnen aufzubringenden Schichten angepasst sind, dass die Lebensdauer der einzelnen Segmente einander angeglichen sind. Auf diese Weise kann die Targetstandzeit verlängert werden.

Das erfindungsgemäße Verfahren zur Aufbringung von dünnen Schichten aus unterschiedlichen Materialien auf einem Substrat durch Magnetronsputtern in einer Vakuumbeschichtungsanlage umfasst nun folgende, sukzessiv auszuführende Schritte. Eine um die axiale Längsrichtung drehbar gelagerte Zylinderkathode, die mindestens zwei Segmente mit unterschiedlichen Materialien umfasst, wird während der Aufbringung einer Schicht auf dem Substrat um die Längsachse über einem innenliegenden Magnetsystem oszillierend gedreht, in dem die Drehung abwechselnd im und gegen den Uhrzeigersinn erfolgt und zwar so weit, dass nur Material einer Sorte gesputtert wird. Anschließend wird zum Aufbringen einer nächsten Schicht die Zylinderkathode so weit um die Längsachse gedreht, bis sich das Segment mit dem gewünschten Material über dem Magnetsystem befindet, wobei gegebenenfalls die Plasmaentladung gelöscht und nach Erreichen des nächsten Targetabschnitts wieder erzeugt werden kann. Besonders vorteilhaft kann das Verfahren gestaltet werden, wenn die Lebensdauer der Segmente dadurch angeglichen wird, dass die Volumina der einzelnen Materialsegmente entsprechend den Sputterbedingungen bei der Aufbringung der einzelnen Schichten gestaltet werden. Vor allem für große Substratflächen werden vorteilhaft mehrere in der Magnetronsputtereinrichtung angeordnete Zylinderkathoden zur Schichtabscheidung verwendet. Wenn viele verschiedene Schichten auf einem Substrat aufgebracht werden sollen, kann es sich empfehlen, einzelne Schichtabschnitte, die erste Materialien umfassen, in einer ersten Vakuumkammer aufzubringen und Schichtabschnitte, die weitere Materialien umfassen, in einer oder mehreren weiteren Vakuumkammer aufzubringen.

Gegenüber der Verwendung von mehreren Planartargets hat die vorbeschriebene Erfindung den Vorteil, dass durch die Bewegung des Targets während des Sputterprozesses eine höhere Targetausnutzung und eine deutlich geringere Redeposition erreicht wird. Hingegen besteht der Vorteil gegenüber dem System, eine Schicht pro Kammer aufzubringen, darin, dass die Anlagengröße deutlich reduziert ist. So können die Kosten bei der Anschaffung und beim Unterhalt der Beschichtungsanlage reduziert werden und die durch den Substrattransport entstehende Partikelbildung vermieden bzw. reduziert und folglich die Schichteigenschaften verbessert werden.

Vor allem für große Substrate werden vorteilhaft mehrere in der Magnetronsputtereinrichtung angeordnete Zylinderkathoden zur Schichtabscheidung verwendet. So kann die Schichtabscheidung beschleunigt werden. Wenn verschiedene Schichten auf einem Substrat aufgebracht werden sollen, kann es sich außerdem empfehlen, die verschiedenen Mehrkomponentenschichten in zwei oder mehreren Vakuumkammern aufzubringen. So kann eine Verunreinigung der verschiedenen Targets vermieden werden.

Im folgenden wird ein Ausführungsbeispiel anhand einer Zeichnung näher erläutert, darin zeigen
- Fig. 1: eine perspektivische Ansicht einer erfindungsgemäßen Zylinderkathode, die vollständig aus Targetmaterial aufgebaut ist und
- Fig. 2: eine perspektivische Ansicht einer erfindungsgemäßen Zylinderkathode, deren Targetmaterialien auf einem Trägerrohr aufgebracht sind.

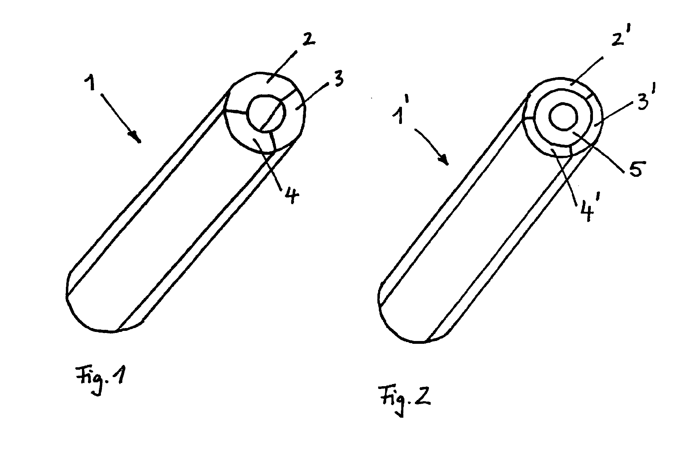

Die erfindungsgemäße Zylinderkathode 1 gemäß Fig. 1 ist als Zylinderrohr ausgebildet. Die Zylinderkathode 1 besteht vollständig aus Targetmaterial und umfasst im dargestellten Fall drei Targetmaterialien. Jedes Targetmaterial befindet sich in einem gesonderten Zylindersegment 2, 3 und 4. Die drei Segmente 2, 3 und 4 weisen jeweils einen Kreisbogen von 120° auf und eine gemeinsame Länge, die der Länge der Zylinderkathode 1, 1' entspricht. Zur Bildung der Zylinderkathode 1 werden die Segmente mittels Verschweißen, Löten oder mechanischen Lösungen wie beispielsweise einer Schwalbenschwanzführung direkt miteinander verbunden.

Wenn das Material aufgrund seiner Eigenschaften oder des Herstellungsprozesses einen direkten Aufbau der Zylinderkathode aus Targetmaterial nicht zulässt, wird die Zylinderkathode 1' auf einfache Weise durch Auftragen von verschiedenem Targetmaterial auf einem Trägerrohr 5 gebildet, wie in Fig. 2 dargestellt. Die einzelnen Zylindersegmente 2', 3' und 4' können z.B. durch Plasmaspritzen auf dem Trägerrohr 5 aufgebracht sein. Sie grenzen direkt aneinander und weisen eine gleiche Länge und gleiche Kreisbögen von 120° auf.

Zur Verwendung in einer erfindungsgemäßen Magnetronsputtereinrichtung sind die Zylinderkathoden 1 und 1' mit geeigneten Mitteln (nicht gezeigt) versehen, die die Lagerung der Zylinderkathoden 1 und 1' über einem in ihrem Inneren angeordneten bekannten Magnetsystem sowie eine axialsymmetrische Drehbewegung um ihre Längsachse gestatten.

Zur Aufbringung eines Schichtsystems aus aufeinanderfolgenden Schichten unterschiedlichen Materials wird die Zylinderkathode 1 so gedreht, dass sich das Zylindersegment 1 mit dem ersten Material über dem Magnetsystem befindet, wobei gegebenenfalls die Plasmaentladung gelöscht und nach Erreichen des nächsten Targetabschnitts wieder erzeugt werden kann. Dieses Material kann nun mit Hilfe des bekannten Magnetroneffekts auf einem Substrat aufgebracht werden. Zur optimalen Ausnutzung des Targetmaterials wird die Zylinderkathode 1 während des Aufbringens des ersten Materials oszillierend, also abwechselnd im und gegen den Uhrzeigersinn soweit gedreht, dass jeweils nur Material aus dem ersten Segment 1 gesputtert wird. Nach Erreichen der erforderlichen Dicke der ersten Materialschicht, wird die Zylinderkathode zum zweiten Segment 2 gedreht und wiederum durch abwechselndes Drehen im und gegen den Uhrzeigersinn das zweite Material auf dem Substrat aufgebracht. Dieses Verfahren kann nun mit dem dritten Segment 3 fortgesetzt werden.

Natürlich können auch zwei oder mehr als drei Segmente zur Bildung der Zylinderkathoden 1 und 1' verwendet werden, wenn es erforderlich ist. Falls die Schichtdicken der einzelnen Materialien unterschiedlich sind, können die Volumina der einzelnen Segmente auf einfache Weise dadurch angepasst werden, dass die Segmentbreite, also die Kreisbögen unterschiedlich ausgeführt werden. So kann über eine Angleichung der Segmentvolumina an die erforderlichen Materialschichtdicken auf dem Substrat die Lebensdauer der einzelnen Segmente einander angeglichen werden und so die Zylinderkathode 1, 1' optimal genutzt werden. Für großflächige Substrate können mehrere Zylinderkathoden 1, 1' in einer Magnetronsputtereinrichtung zum Einsatz kommen. In einer Prozesskette können wiederum mehrere Vakuumkammern mit Magnetronsputtereinrichtungen, die mit jeweils verschiedene Zylinderkathoden mit unterschiedlichen Kombinationen von Targetmaterialien versehen sind, nacheinander angeordnet sein.

Mit der vorliegenden Erfindung ist es also möglich, die Aufbringung von Schichten und Schichtsystemen auf Substraten mittels Magnetronsputtern in Vakuumbeschichtungsanlagen mit deutlich reduzierter Anlagengröße zu erreichen. Durch die Bewegung der Zylinderkathode 1, 1' während der Schichtaufbringung wird eine höhere Targetausnutzung und eine deutlich geringere Redeposition erreicht.

## Patentansprüche

1. Magnetronsputtereinrichtung, insbesondere mit mindestens einer Vakuumkammer, insbesondere zur kontinuierlichen Aufbringung von mehreren Schichten unterschiedlicher Materialien auf einem Substrat, die mit einer um die axiale Längsachse drehbar gelagerten Zylinderkathode (1, 1') und einem Magnetsystem versehen ist, das im Inneren der Zylinderkathode (1, 1') angeordnet ist, **dadurch gekennzeichnet, dass** die Zylinderkathode (1, 1') mindestens zwei Segmente (2, 2', 3, 3', 4, 4') mit unterschiedlichen Targetmaterialien umfasst und die Magnetronsputtereinrichtung Mittel zum Drehen der Zylinderkathode (1, 1') aufweist, mit deren Hilfe zur Aufbringung einer Schicht die Zylinderkathode (1, 1') so weit um die Längsachse gedreht wird, bis sich das Segment (2, 2', 3, 3', 4, 4') mit dem gewünschten Material über dem Magnetsystem befindet, dass die Magnetronsputtereinrichtung Mittel zum Oszillieren der Zylinderkathode (1, 1') um die Längsachse über dem innenliegenden Magnetsystem aufweist, wobei die Oszillation während der Aufbringung der Schichten durch Drehung abwechselnd im und gegen den Uhrzeigersinn erfolgt und dass die Mittel zum Oszillieren eine Begrenzungseinrichtung aufweisen, so dass nur Material einer Sorte gesputtert wird.

2. Magnetronsputtereinrichtung gemäß Anspruch 1, **dadurch gekennzeichnet, dass** die Magnetronsputtereinrichtung mehrere Zylinderkathoden (1, 1') umfasst.

3. Magnetronsputtereinrichtung gemäß Anspruch 2, **dadurch gekennzeichnet, dass** die Zylinderkathoden (1, 1') unterschiedliche Kombinationen von Targetmaterialien aufweisen.

4. Zylinderkathode (1, 1'), insbesondere zur Verwendung in einer Magnetronsputtervorrichtung gemäß einem der Ansprüche 1 bis 3, **dadurch gekennzeichnet, dass** die Zylinderkathode (1, 1') mindestens zwei Segmente (2, 2', 3, 3', 4, 4') mit unterschiedlichen Targetmaterialien umfasst.

5. Zylinderkathode (1, 1') gemäß Anspruch 4, **dadurch gekennzeichnet, dass** die einzelnen Segmente (2, 2', 3, 3', 4, 4') als Zylindersegmente ausgebildet sind.

6. Zylinderkathode (1') gemäß Anspruch 4 oder 5, **dadurch gekennzeichnet, dass** die einzelnen Segmente (2', 3', 4') auf einem Trägerrohr (5) angeordnet sind.

7. Zylinderkathode (1, 1') gemäß einem der Ansprüche 4 bis 6, **dadurch gekennzeichnet, dass** die einzelnen Segmente (2, 2', 3, 3', 4, 4') direkt aneinander grenzen.

8. Zylinderkathode (1') gemäß einem der Ansprüche 4 bis 6, **dadurch gekennzeichnet, dass** die einzelnen Segmente (2', 3', 4') mit Abstand zueinander so angeordnet sind, dass gerade noch keine Entladung im Spalt zwischen den Segmenten (2', 3', 4') auftreten kann.

9. Zylinderkathode (1, 1') gemäß einem der Ansprüche 4 bis 8, **dadurch gekennzeichnet, dass** die einzelnen Segmente (2, 2', 3, 3', 4, 4') solche Kreisbögen aufweisen, dass die Volumina der Segmente (2, 2', 3, 3', 4, 4') so den Sputterbedingungen der einzelnen aufzubringenden Schichten angepasst sind, dass die Lebensdauer der einzelnen Segmente (2, 2', 3, 3', 4, 4') einander angeglichen ist.

10. Verfahren zur Aufbringung von dünnen Schichten aus unterschiedlichen Materialien auf einem Substrat durch Magnetronsputtern in einer Vakuumbeschichtungsanlage, mit einer um die axiale Längsachse drehbar gelagerten Zylinderkathode (1, 1') in einer Magnetronsputtereinrichtung, **dadurch gekennzeichnet, dass** die Zylinderkathode (1, 1') mindestens zwei Segmente (2, 2', 3, 3', 4, 4') mit unterschiedlichen Materialien umfasst und während der Aufbringung der Schichten auf dem Substrat um die Längsachse über dem innenliegenden Magnetsystem gedreht wird,
wobei die Drehung abwechselnd im und gegen den Uhrzeigersinn erfolgt und zwar so weit, dass nur Material einer Sorte gesputtert wird und
zum Aufbringen einer nächsten Schicht die Zylinderkathode (1, 1') so weit um die Längsachse gedreht wird, bis das Segment (2, 2', 3, 3', 4, 4') mit dem gewünschten Material sich über dem Magnetsystem befindet.

11. Verfahren gemäß Anspruch 10, **dadurch gekennzeichnet, dass** die Zylinderkathode (1, 1') gemäß einem der Ansprüche 4 bis 8 ausgeführt ist.

12. Verfahren gemäß Anspruch 10 oder 11, **dadurch gekennzeichnet, dass** die Lebensdauer der einzelnen Segmente (2, 2', 3, 3', 4, 4') der Zylinderkathode (1, 1') dadurch angeglichen wird, dass die Volumina der einzelnen Materialsegmente (2, 2', 3, 3', 4, 4') entsprechend den Sputterbedingungen bei der Aufbringung der einzelnen Schichten gestaltet werden.

13. Verfahren gemäß einem der Ansprüche 10 bis 12, **dadurch gekennzeichnet, dass** die verschiedenen Schichten von mehreren in der Magnetronsputtereinrichtung angeordneten Zylinderkathoden (1, 1') auf dem Substrat aufgebracht werden.

14. Verfahren gemäß einem der Ansprüche 10 bis 13, **dadurch gekennzeichnet, dass** die verschiedenen Schichten von mehreren, in mindestens zwei Vakuumkammern in der Beschichtungsanlage angeordneten Magnetronsputtereinrichtungen auf dem Substrat aufgebracht werden, wobei das Substrat die einzelnen Vakuumkammern ohne Unterbrechung des Vakuums durchläuft.

15. Verfahren gemäß einem der Ansprüche 10 bis 14, **dadurch gekennzeichnet, dass** die Plasmaentladung während des Segmentwechsels gelöscht und nach Erreichen des nächsten Segments wieder erzeugt wird.
